# EUROPEAN PATENT APPLICATION

(11) **EP 4 545 678 A1**
(43) Date of publication of application: **30.04.2025**
(21) Application number: 23826210.9
(22) Date of filing: 13.06.2023
(51) Int. Cl.: C23C 14/50, C23C 14/35, H01L 21/687, H01J 37/34

(54) **SEMICONDUCTOR PROCESS APPARATUS AND BEARING DEVICE THEREFOR**

(30) Priority: 24.06.2022 CN 202210738846
(71) Applicant: Beijing NAURA Microelectronics Equipment Co., Ltd., Beijing 100176 (CN)
(72) Inventor: JI, Kehong, Beijing 100176 (CN); LI, Dongdong, Beijing 100176 (CN)
(74) Representative: Cohausz & Florack
(86) International application number: PCT/CN2023/099884
(87) International publication number: WO 2023/246561

(57) **Abstract**

The present disclosure provides a semiconductor process apparatus and a bearing device therefor, and relates to the semiconductor process technology. The bearing device for the semiconductor process apparatus includes: a base, which includes a first surface and a second surface, the first surface being configured to bear a wafer, a height of the second surface being smaller than a height of the first surface, and the second surface being disposed around the first surface; a deposition ring, which includes an upper surface provided with an annular groove, and a lower surface covering the second surface; and a cover ring, an outer ring portion of the cover ring being supported on a liner of a reaction chamber of the semiconductor process apparatus, an inner ring portion of the cover ring covering an outer ring portion of the deposition ring, and a plurality of annular protrusions and a plurality of annular recesses being disposed at two opposite surfaces between the inner ring portion of the cover ring and the outer ring portion of the deposition ring, so as to form a labyrinth passage between the annular groove and contact parts of the cover ring and the deposition ring. The bearing device of the present disclosure can effectively reduce probability of adhesion between the cover ring and the deposition ring during a semiconductor processing process.

## Description

### TECHNICAL FIELD

The present disclosure belongs to the field of semiconductor process technology, and particularly relates to a semiconductor process apparatus and a bearing device therefor.

### BACKGROUND

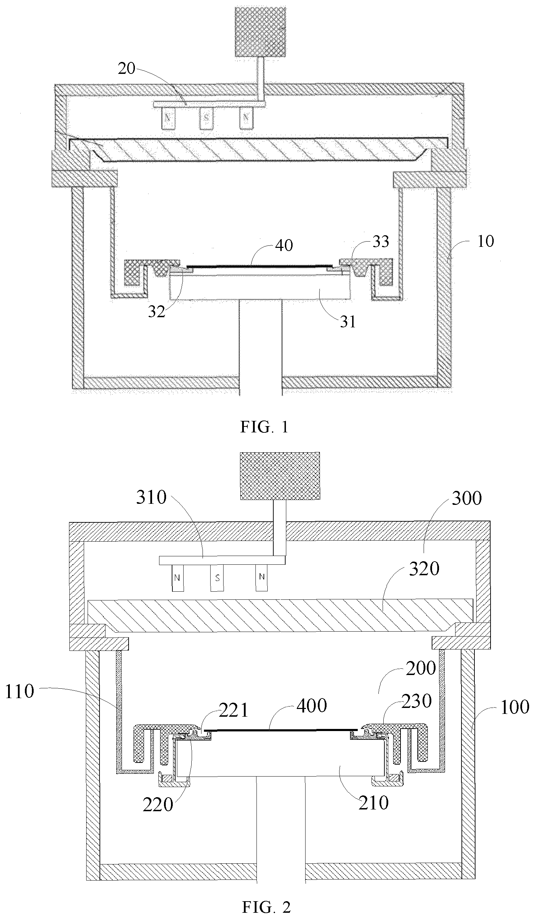

At present, the technique of making interconnect lines of aluminum and aluminum alloys in a semiconductor manufacturing process is widely applied to a metallization process of chip manufacturing. A common manufacturing process is a magnetron sputtering, and a typical magnetron sputtering apparatus is shown in FIG. 1. The magnetron sputtering apparatus is provided with a reaction chamber 10, a semiconductor process assembly 20 for performing magnetron sputtering is disposed in an upper portion of the reaction chamber 10, and a bearing device for bearing a wafer 40 is disposed in a lower portion of the reaction chamber 10. The bearing device mainly includes a base 31, a deposition ring 32, and a cover ring 33. A bottom surface of the deposition ring 32 is flat and is directly placed on the base 31; and a top surface of the deposition ring 32 is provided with a groove for deposition of a reactant generated during a magnetron sputtering process, so as to protect a surface of the base 31 against contamination by the reactant. In the existing art, since contact parts of the cover ring 33 and the deposition ring 32 are relatively close to the groove, after the magnetron sputtering process lasts for a period of time, the contact parts of the cover ring 33 and the deposition ring 32 adhere to each other as the reactant deposited in the groove increases, such that the deposition ring 32 is also lifted when the cover ring 33 is lifted, resulting in the falling of the deposition ring 32. Meanwhile, since an inner diameter of the deposition ring 32 is generally smaller than a diameter of the wafer 40, the lifted deposition ring 32 will lift the wafer 40 at the same time, resulting in a wafer transfer failure and chipping of the wafer 40.

### SUMMARY

Embodiments of the present disclosure provide a semiconductor process apparatus and a bearing device therefor, so as to solve the problems of the falling of the deposition ring, the wafer transfer failure and the chipping of the wafer which are caused because the existing bearing device is prone to adhesion during the magnetron sputtering process.

In a first aspect, an embodiment of the present disclosure provides a bearing device for a semiconductor process apparatus, including:
a base, which includes a first surface and a second surface, the first surface being configured to bear a wafer, a height of the second surface being smaller than a height of the first surface, and the second surface being disposed around the first surface;
a deposition ring, which includes an upper surface provided with an annular groove, and a lower surface covering the second surface; and
a cover ring, an outer ring portion of the cover ring being supported on a liner of a reaction chamber of the semiconductor process apparatus, an inner ring portion of the cover ring covering an outer ring portion of the deposition ring, and a plurality of annular protrusions and a plurality of annular recesses being disposed at two opposite surfaces between the inner ring portion of the cover ring and the outer ring portion of the deposition ring, so as to form a labyrinth passage between the annular groove and contact parts of the cover ring and the deposition ring.

In some embodiments of the present disclosure, the plurality of annular protrusions are different in height, and the plurality of annular recesses are different in depth;
the plurality of annular protrusions are all disposed at an upper surface of the outer ring portion of the deposition ring, and the plurality of annular recesses are all disposed at a lower surface of the inner ring portion of the cover ring; or
the plurality of annular protrusions are all disposed at the lower surface of the inner ring portion of the cover ring, and the plurality of annular recesses are all disposed at the upper surface of the outer ring portion of the deposition ring; or
part of the plurality of annular protrusions and part of the plurality of annular recesses are disposed at the upper surface of the outer ring portion of the deposition ring, and the rest of the plurality of annular protrusions and the rest of the plurality of annular recesses are disposed at the lower surface of the inner ring portion of the cover ring.

In some embodiments of the present disclosure, the inner ring portion of the cover ring has an eave structure, which covers part of the annular groove.

In some embodiments of the present disclosure, the base includes a first cylinder and a second cylinder, the first cylinder and the second cylinder are coaxially arranged and connected to each other, the first cylinder is located on the second cylinder, and a radius of a bottom surface of the first cylinder is smaller than a radius of a bottom surface of the second cylinder, so as to respectively form the first surface and the second surface on an upper side of the base; and an inner ring portion of the deposition ring and an outer sidewall of the first cylinder are positioned by engagement of a plurality of first positioning bosses and a plurality of first positioning grooves in a one-to-one correspondence manner.

In some embodiments of the present disclosure, the inner ring portion of the cover ring and the outer ring portion of the deposition ring are positioned by engagement of a plurality of second positioning bosses and a plurality of second positioning grooves in a one-to-one correspondence manner.

Optionally, in some embodiments of the present disclosure, the outer ring portion of the deposition ring is further provided with a plurality of buckle slots, the bearing device further includes a plurality of buckles, and the outer ring portion of the deposition ring is fastened to the base by engagement of the plurality of buckles and the plurality of buckle slots in a one-to-one correspondence manner.

In some embodiments of the present disclosure, each of the buckles includes a buckle rod, a first hook is provided at one end of the buckle rod to be hooked to a corresponding buckle slot, and a second hook is provided at the other end of the buckle rod to be hooked to a bottom surface of the base.

In some embodiments of the present disclosure, the buckle slot is a T-shaped slot, and the first hook is a T-shaped hook which fits the T-shaped slot.

In some embodiments of the present disclosure, the bearing device further includes:
a fixing ring, which is disposed around an outer sidewall of the base, and fastens the plurality of buckles to the outer sidewall of the base.

In some embodiments of the present disclosure, a third hook is provided at the other end of the buckle rod to be hooked to the fixing ring.

In a second aspect, an embodiment of the present disclosure provides a semiconductor process apparatus, including the bearing device described above, a reaction chamber with enclosed space, and a semiconductor processing assembly, wherein the bearing device and the semiconductor processing assembly are disposed in the enclosed space.

In the present disclosure, the bearing device includes the base, the deposition ring, and the cover ring; wherein the inner ring portion of the cover ring covers the outer ring portion of the deposition ring, and the plurality of annular protrusions and the plurality of annular recesses are disposed between the inner ring portion of the cover ring and the outer ring portion of the deposition ring, so as to form the labyrinth passage between the cover ring and the deposition ring. In this way, due to the labyrinth passage formed between the annular groove and the contact parts of the cover ring and the deposition ring, a distance for a reactant which is deposited in the annular groove during a semiconductor processing process to reach the contact parts is greatly increased; and meanwhile, the reactant needs to pass across multiple labyrinth shields before reaching the contact parts, so that the difficulty of the reactant in reaching the contact parts is greatly increased. Therefore, the bearing device of the present disclosure can effectively reduce the probability of adhesion between the cover ring and the deposition ring during the semiconductor processing process.

### BRIEF DESCRIPTION OF DRAWINGS

The technical solutions and beneficial effects of the present disclosure will become apparent from the following description of specific implementations of the present disclosure with reference to the accompanying drawings.
FIG. 1 is a sectional view of a structure of a magnetron sputtering apparatus in the existing art.
FIG. 2 is a sectional view of a structure of a semiconductor process apparatus according to an embodiment of the present disclosure.
FIG. 3 is an enlarged view of part of a structure of the semiconductor process apparatus shown in FIG. 2.
FIG. 4 is a schematic structural diagram of a base of the semiconductor process apparatus shown in FIG. 2.
FIG. 5 is a schematic structural diagram of a deposition ring of the semiconductor process apparatus of FIG. 2.
FIG. 6 is a schematic structural diagram of an assembly structure of a base and a deposition ring of the semiconductor process apparatus shown in FIG. 2.
FIG. 7 is a schematic structural diagram of a first positioning boss of the deposition ring shown in FIG. 5.
FIG. 8 is a schematic structural diagram of a cover ring of the semiconductor process apparatus shown in FIG. 2.
FIG. 9 is a schematic structural diagram of a buckle slot of the deposition ring shown in FIG. 5.
FIG. 10 is a schematic structural diagram of a buckle of the semiconductor process apparatus shown in FIG. 3.

### DETAIL DESCRIPTION OF EMBODIMENTS

The technical solutions of the embodiments of present disclosure are clearly and completely described below with reference to the drawings. Apparently, the embodiments described herein are merely some embodiments of the present disclosure, rather than all embodiments. All other embodiments, which are derived by those of ordinary skill in the art based on the embodiments in the present disclosure without any inventive work, fall within the scope of the present disclosure. The embodiments below and the technical features therein may be combined with each other if no conflict is incurred.

At present, the technique of making interconnect lines of aluminum and aluminum alloys in a semiconductor manufacturing process is widely applied to a metallization process of chip manufacturing. A common manufacturing process is a magnetron sputtering method, and a typical magnetron sputtering apparatus is shown in FIG. 1. The magnetron sputtering apparatus is provided with the reaction chamber 10, the semiconductor process assembly 20 for performing magnetron sputtering is disposed in the upper portion of the reaction chamber 10, and the bearing device for bearing the wafer 40 is disposed in the lower portion of the reaction chamber 10. The bearing device mainly includes the base 31, the deposition ring 32, and the cover ring 33. The bottom surface of the deposition ring 32 is flat and is directly placed on the base 31; and the top surface of the deposition ring 32 is provided with the groove for deposition of a reactant generated during a magnetron sputtering process, so as to protect the surface of the base 31 against contamination by the reactant. In the existing art, since contact parts of the cover ring 33 and the deposition ring 32 are relatively close to the groove, after the magnetron sputtering process lasts for a period of time, the contact parts of the cover ring 33 and the deposition ring 32 adhere to each other as the reactant deposited in the groove increases, such that the deposition ring 32 is also lifted when the cover ring 33 is lifted, resulting in the falling of the deposition ring 32. Meanwhile, since the inner diameter of the deposition ring 32 is generally smaller than the diameter of the wafer 40, the lifted deposition ring 32 can lift the wafer 40 at the same time, resulting in a wafer transfer failure and chipping of the wafer 40.

In view of the above, there is a need to propose a new solution for the bearing device, so as to solve the problems of the falling of the deposition ring, the wafer transfer failure and the chipping of the wafer which are caused because the existing bearing device is prone to adhesion during the magnetron sputtering process.

As shown in FIG. 2 to FIG. 4, in an embodiment, the present disclosure provides a semiconductor process apparatus, including a reaction chamber 100 with enclosed space, a bearing device 200, and a semiconductor processing assembly 300, with the bearing device 200 and the semiconductor processing assembly 300 separately disposed in the enclosed space. The bearing device 200 may include a base 210, a deposition ring 220, and a cover ring 230. The base 210 may include a first surface 2111 and a second surface 2121, the first surface 2111 is configured to bear a wafer 400, a height of the second surface 2121 is smaller than that of the first surface 2111, and the second surface 2121 is disposed around the first surface 2111. The deposition ring 220 may include an upper surface provided with an annular groove 221, and a lower surface covering the second surface 2121 for protecting the second surface 2121 against contamination by a reactant during a semiconductor processing process on the wafer 400. The cover ring 230 may be configured to cover a gap between the base 210 and a liner 110 of the reaction chamber 100 of the semiconductor process apparatus, so as to prevent the reactant from contaminating a lower region of the reaction chamber 100, an outer ring portion of the cover ring 230 is supported on the liner 110 of the reaction chamber 100 of the semiconductor process apparatus, an inner ring portion of the cover ring 230 covers an outer ring portion of the deposition ring 220, and a plurality of annular protrusions and a plurality of annular recesses are disposed between the inner ring portion of the cover ring 230 and the outer ring portion of the deposition ring 220, so as to form a labyrinth passage between the annular groove 221 and contact parts of the cover ring 230 and the deposition ring 220.

It should be noted that the semiconductor process apparatus may be a magnetron sputtering apparatus, in which case the semiconductor processing assembly 300 is a magnetron sputtering assembly, which may include a magnetron system 310, a target 320, and an upper electrode system (not shown). The target 320 is located above the bearing device 200, and forms a closed cavity in the upper portion of the reaction chamber 100, and the closed cavity may be filled with deionized water. When a magnetron sputtering process is performed on the wafer 400 on the bearing device 200, a direct current (DC) power supply of the upper electrode system may apply a bias voltage to the target 320 to endow the target 320 with a negative bias voltage relative to the grounded chamber, so that a process gas such as argon may discharge to generate plasma, and meanwhile positively charged argon ions are attracted to the target 320 under the action of the negative bias voltage. When the energy of the argon ions is high enough and the argon ions bombard the target 320 under the action of a magnetic field generated by the magnetron system 310, metal atoms are caused to escape from a surface of the target 320 and are deposited on the wafer 400 through diffusion, thereby completing the magnetron sputtering process on the wafer 400. It is apparent to those of ordinary skill in the art that the semiconductor process apparatus may be an apparatus for performing other semiconductor processing processes on the wafer 400, in which case the semiconductor processing assembly 300 may be simply replaced with assemblies capable of performing the corresponding semiconductor processing processes.

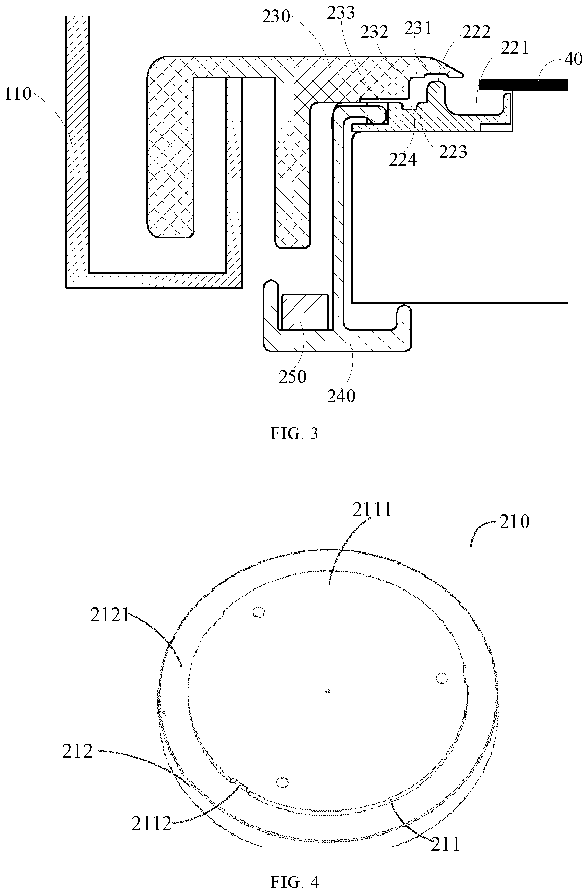

As shown in FIG. 2 and FIG. 3, a main objective of forming the labyrinth passage between the annular groove 221 and the contact parts of the cover ring 230 and the deposition ring 220 by providing the plurality of annular protrusions and the plurality of annular recesses between the inner ring portion of the cover ring 230 and the outer ring portion of the deposition ring 220 in the present embodiment is to increase the difficulty of the reactant deposited in the annular groove in reaching the contact parts, so as to reduce the probability of adhesion of the contact parts. Therefore, the number of the plurality of annular protrusions and the number of the plurality of annular recesses may be set as much as possible according to an actual setting environment. The plurality of annular protrusions are different in height, the plurality of annular recesses are different in depth, and a certain gap is provided between the highest point of an annular protrusion and the lowest point of a corresponding annular recess, so as to better form the labyrinth passage. According to actual needs, the plurality of annular protrusions may be all disposed at an upper surface of the outer ring portion of the deposition ring 220, or all disposed at a lower surface of the inner ring portion of the cover ring 230, or part of the plurality of annular protrusions may be disposed at the upper surface of the outer ring portion of the deposition ring 220 and the rest of the plurality of annular protrusions may be disposed at the lower surface of the inner ring portion of the cover ring 230. Similarly, according to actual needs, the plurality of annular recesses may be all disposed at the upper surface of the outer ring portion of the deposition ring 220, or all disposed at the lower surface of the inner ring portion of the cover ring 230, or part of the plurality of annular recesses may be disposed at the upper surface of the outer ring portion of the deposition ring 220 and the rest of the plurality of annular recesses may be disposed at the lower surface of the inner ring portion of the cover ring 230.

In order to enable the labyrinth passage to better prevent the reactant deposited in the annular groove 221 from reaching the contact parts of the cover ring 230 and the deposition ring 220, an entrance of the labyrinth passage may be located on a top side of an outer sidewall of the annular groove 221, and is located at a horizontal height greater than that of the contact parts of the cover ring 230 and the deposition ring 220. Preferably, the inner ring portion of the cover ring may have an eave structure covering part of the annular groove. Taking the case illustrated by FIG. 3 as an example, the plurality of annular protrusions may include a first annular protrusion 222 and a second annular protrusion 223 which are respectively disposed at the upper surface of the outer ring portion of the deposition ring 220, and the plurality of annular recesses include a first annular recess 224 disposed at the upper surface of the outer ring portion of the deposition ring 220, and a second annular recess 231, a third annular recess 232, and a third annular recess 233 which are respectively disposed at the lower surface of the inner ring portion of the cover ring 230. The first annular protrusion 222 may be formed on the outer sidewall of the annular groove 221, that is, integrally formed with the outer sidewall of the annular groove 221, so as to form a first labyrinth shield against the reactant which is deposited in the annular groove 221 during the semiconductor processing process. A top side (i.e., the highest point) of the first annular protrusion 222 is spaced apart from a bottom wall (i.e., the lowest point) of the corresponding second annular recess 231 by a first preset distance, a height of the second annular protrusion 223 is smaller than that of the first annular protrusion 222, a top side (i.e., the highest point) of the second annular protrusion 223 is spaced apart from a bottom wall (i.e., the lowest point) of the corresponding third annular recess 232 by a second preset distance, and the third annular recess 233 is disposed adjacent to the contact parts, thereby forming the labyrinth passage together. Furthermore, the contact of the cover ring 230 with the deposition ring 220 is realized in such a way that the cover ring 230 contacts an outermost edge of the deposition ring 220; and with the third annular recess 233 disposed adjacent to the contact parts, the contact of the cover ring 230 with the deposition ring 220 is realized in such a way that an outer sidewall (which may form a certain protrusion) of the third annular recess 233 contacts the outermost edge of the deposition ring 220, so that a channel with a certain length is formed between a bottom wall (i.e., the lowest point) of the third annular recess 233 and the upper surface of the outer ring portion of the deposition ring 220. In this way, even if the reactant passes across the first labyrinth shield, the reactant needs to pass through the long channel before reaching the contact parts. Thus, a second labyrinth shield is formed.

Thus, due to the labyrinth passage formed between the annular groove 221 and the contact parts of the cover ring 230 and the deposition ring 220, a distance for the reactant which is deposited in the annular groove 221 during the semiconductor processing process to reach the contact parts is greatly increased; and meanwhile, the reactant needs to pass across multiple labyrinth shields before reaching the contact parts, so that the difficulty of the reactant in reaching the contact parts is greatly increased. Therefore, the bearing device of the present disclosure can effectively reduce the probability of adhesion between the cover ring 230 and the deposition ring 220 during the semiconductor processing process.

In some examples, as shown in FIG. 4, the base 210 includes a first cylinder 211 and a second cylinder 212. The first cylinder 211 and the second cylinder 212 are vertically and concentrically arranged and connected to each other, that is, the first cylinder 211 and the second cylinder 212 are coaxially arranged and connected to each other, the first cylinder 211 is located on the second cylinder 212, and a radius of a bottom surface of the first cylinder 211 is smaller than that of a bottom surface of the second cylinder 212, so as to respectively form the first surface 2111 and the second surface 2121 on an upper side of the base 210. In order to better bear the wafer 400 on the first surface 2111, a diameter of the first surface 2111 may be smaller than that of the wafer 400. Meanwhile, in order to meet the requirements of some semiconductor process apparatuses for heating the wafer 400 during semiconductor processing processes, the base 210 may be provided therein with some conventional heating structures, so as to perform corresponding heating processes on the base 210.

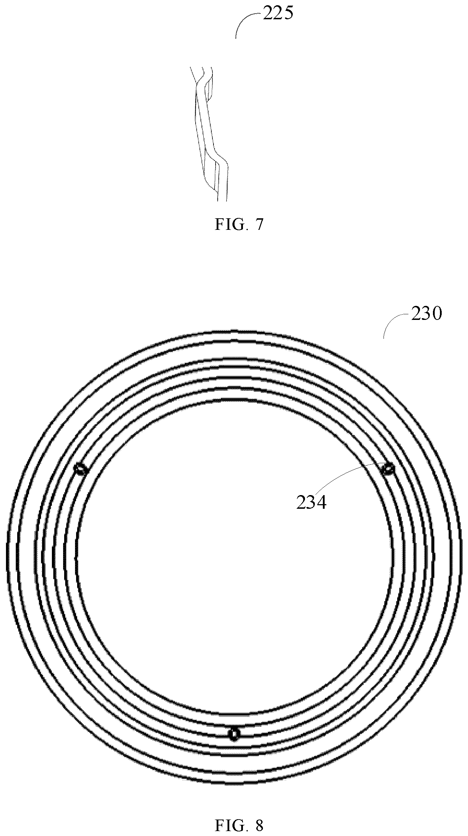

In some examples, as shown in FIG. 4, FIG. 5, and FIG. 6, an inner ring portion of the deposition ring 220 and an outer sidewall of the first cylinder 211 are positioned by engagement of a plurality of first positioning bosses 225 and a plurality of first positioning grooves 2112 in a one-to-one correspondence manner. For those of ordinary skill in the art, both the number of the first positioning bosses 225 and the number of the first positioning grooves 2112 may be arbitrarily reduced according to actual needs as long as it is ensured that the number of the first positioning bosses 225 is equal to the number of the first positioning grooves 2112. Meanwhile, according to actual needs, the plurality of first positioning bosses 225 may be all disposed on an inner circumferential side of the deposition ring 220, or all disposed at the outer sidewall of the first cylinder 211, or part of the plurality of first positioning bosses 225 may be disposed on the inner circumferential side of the deposition ring 220, and the rest of the plurality of first positioning bosses 225 may be disposed at the outer sidewall of the first cylinder 211. Similarly, according to actual needs, the plurality of first positioning grooves 2112 may be all disposed on the inner circumferential side of the deposition ring 220, or all disposed at the outer sidewall of the first cylinder 211, or part of the plurality of first positioning grooves 2112 may be disposed on the inner circumferential side of the deposition ring 220, and the rest of the plurality of first positioning grooves 2112 may be disposed at the outer sidewall of the first cylinder 211. Taking the case illustrated by FIG. 4, FIG. 5, and FIG. 6 as an example, both the number of the first positioning bosses 225 and the number of the first positioning grooves 2112 may be three. In such case, the three first positioning bosses 225 are all disposed on the inner circumferential side of the deposition ring 220, and are distributed in an equilateral triangle to ensure stability of a final positioning effect. Correspondingly, the three first positioning grooves 2112 are all disposed at the outer sidewall of the first cylinder 211, and are also correspondingly distributed in an equilateral triangle, so that each first positioning boss 225 may be correspondingly engaged in the corresponding first positioning groove 2112. In addition, in order to further ensure firmness of the engagement, each first positioning boss 225 may be a trapezoidal bass shown in FIG. 7. Correspondingly, each first positioning groove 2112 may be a trapezoidal groove shown in FIG. 4 which fits the trapezoidal boss.

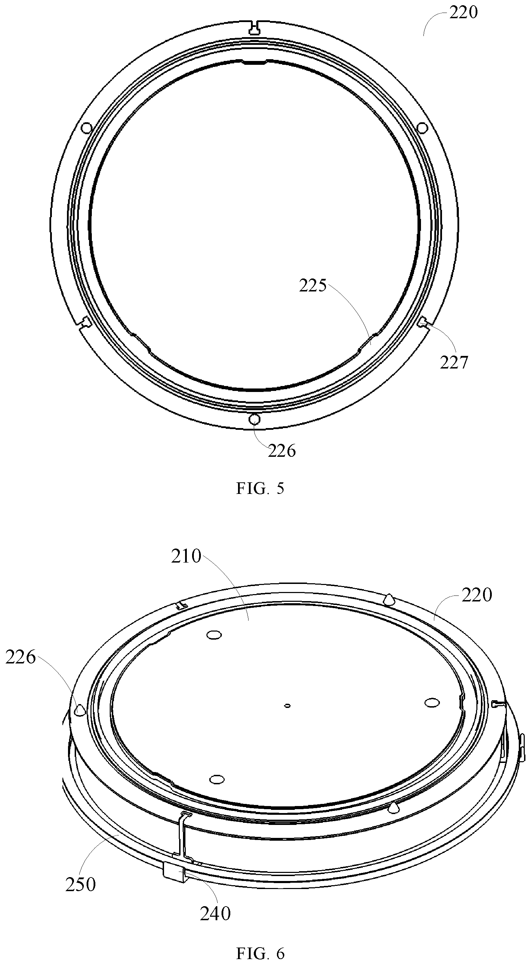

In some examples, in order to ensure that a center of the cover ring 230 always coincides with a center of the deposition ring 220 to avoid a shift of a process result, as shown in FIG. 5, FIG. 6, and FIG. 8, the inner ring portion of the cover ring 230 and the outer ring portion of the deposition ring 220 are positioned by engagement of a plurality of second positioning bosses 226 and a plurality of second positioning grooves 234 in a one-to-one correspondence manner. For those of ordinary skill in the art, both the number of the second positioning bosses 226 and the number of the second positioning grooves 234 may be arbitrarily reduced according to actual needs as long as it is ensured that the number of the second positioning bosses 226 is equal to the number of the second positioning grooves 234. Meanwhile, according to actual needs, the plurality of second positioning bosses 226 may be all disposed at the upper surface of the outer ring portion of the deposition ring 220, or all disposed at the lower surface of the inner ring portion of the cover ring 230, or part of the plurality of second positioning bosses 226 may be disposed at the upper surface of the outer ring portion of the deposition ring 220, and the rest of the plurality of second positioning bosses 226 may be disposed at the lower surface of the inner ring portion of the cover ring 230. Similarly, according to actual needs, the plurality of second positioning grooves 234 may be all disposed at the upper surface of the outer ring portion of the deposition ring 220, or all disposed at the lower surface of the inner ring portion of the cover ring 230, or part of the plurality of second positioning grooves 234 may be disposed at the upper surface of the outer ring portion of the deposition ring 220, and the rest of the plurality of second positioning grooves 234 may be disposed at the lower surface of the inner ring portion of the cover ring 230. Taking the case illustrated by FIG. 5, FIG. 6, and FIG. 8 as an example, both the number of the second positioning bosses 226 and the number of the second positioning grooves 234 may be three. In such case, the three second positioning bosses 226 are all disposed at the upper surface of the outer ring portion of the deposition ring 220, and are distributed in an equilateral triangle to ensure stability of a final positioning effect. Correspondingly, the three second positioning grooves 234 are all disposed at the lower surface of the inner ring portion of the cover ring 230, and are also correspondingly distributed in an equilateral triangle, so that each second positioning boss 226 may be correspondingly engaged in the corresponding second positioning groove 234. In addition, in order to further ensure firmness of the engagement, each second positioning boss 226 may be a trapezoidal bass shown in FIG. 6. Correspondingly, each second positioning groove 234 may be a trapezoidal groove shown in FIG. 4 which fits the trapezoidal boss.

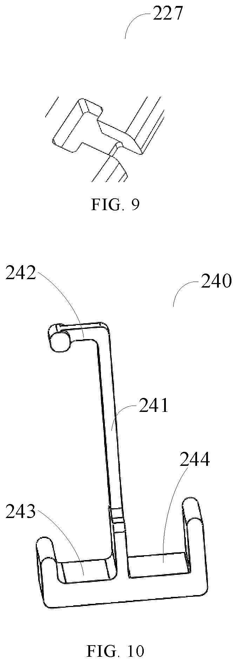

Since the reactant deposited in the annular groove 221 may be continuously increased after duration of a semiconductor process (which may be a magnetron sputtering process) on the wafer 400 on the bearing device 200 is increased, the possibility of the reactant passing through the labyrinth passage to reach the contact parts of the cover ring 230 and the deposition ring 220 is increased. In view of this, in some examples, as shown in FIG. 2, FIG. 3, and FIG. 5, the outer ring portion of the deposition ring 220 is further provided with a plurality of buckle slots 227, the bearing device further includes a plurality of buckles 240, the outer ring portion of the deposition ring 220 is fastened to the base 210 by engagement of the plurality of buckles 240 and the plurality of buckle slots 227 in a one-to-one correspondence manner. In this way, the deposition ring 220 is firmly fastened on the base 210 by the engagement of the plurality of buckles 240 and the plurality of buckle slots 227 in a one-to-one correspondence manner, so that even if the contact parts of the cover ring 230 and the deposition ring 220 adhere to each other, the deposition ring 220 is not lifted when the cover ring 230 is lifted. It is apparent to those of ordinary skill in the art that the number of the buckle slots 227 may be arbitrarily reduced according to actual needs. In order to further firmly fasten the deposition ring 220 on the base 210, the number of the buckle slots 227 may be three, and the three buckle slots 227 are distributed in an equilateral triangle. Meanwhile, as shown in FIG. 3, FIG. 9, and FIG. 10, each buckle 240 may include a buckle rod 241, a first hook 242 is provided at one end of the buckle rod 241 to be hooked to a corresponding buckle slot 227, and a second hook 243 is provided at the other end of the buckle rod 241 to be hooked to a bottom surface of the base 210. In this way, when each buckle 240 is mounted, the first hook 242 may be disposed in the corresponding buckle slot 227, and then the buckle 240 may be rotated around a top end of the buckle rod 241 as a center to hook the second hook 243 to the bottom surface of the base 210, thereby completing the installation of the corresponding buckle 240. In order to further ensure installation firmness of the first hook 242 and prevent the first hook 242 from falling off from the corresponding buckle slot 227, the buckle slot 227 may be a T-shaped slot, and the first hook 242 may be a T-shaped hook which fits the T-shaped slot. Meanwhile, each of two ends of a horizontal portion of the T-shaped hook may be provided with a cylindrical head, so as to further enhance the connection of the first hook 242 to the corresponding buckle slot 227.

Finally, with the three buckles 240, the deposition ring 220 can be firmly fastened on the base 210, and the freedom of the deposition ring 220 to move up and down can be limited. However, the possibility of circumferential movement of the deposition ring 220 still exists, which may cause the buckles 240 to fall off. In view of this, in some examples, as shown in FIG. 2, FIG. 3, and FIG. 6, the bearing device 200 further includes a fixing ring 250, which is disposed around an outer sidewall of the base 210, and fastens the plurality of buckles 240 to the outer sidewall of the base 210. Furthermore, a third hook 244 is provided at the other end of the buckle rod 241 to be hooked to the fixing ring. In this way, by placing the fixing ring 250 in the third hook 244 of each buckle 240, the circumferential freedom of each buckle 240 is limited, which can prevent the buckle 240 from being rotated and falling off.

**In** an embodiment, the present disclosure further provides a bearing device for a semiconductor process apparatus. A structure and functions of the bearing device may be found in the description of the bearing device provided in the above embodiments, and are not described in detail here.

Although the present disclosure is described by illustration of one or more implementations, variations and modifications may be envisaged by those of ordinary skill in the art based on reading and understanding of the description and the drawings of the present disclosure. The present disclosure includes all those modifications and variations, and is limited only by the scope of the appended claims. In particular, for each function performed by the aforesaid components, the terms used to describe the components are intended to be corresponding to any component (that is functionally equivalent, for example) which performs the specified function of the described components (unless otherwise indicated), even if the any component has a structure different from the disclosed structure which performs the function in the exemplary implementations illustrated herein.

That is, what is described above is just the embodiments of the present disclosure, and is not intended to limit the scope of the present disclosure, and all equivalent structures or equivalent flow transformations derived from the contents of the description and the drawings of the present disclosure, such as the combinations of the technical features of the embodiments or direct or indirect applications of the technical features of the embodiments to other related technical fields, are included in the scope of the present disclosure.

In addition, in the description of the present disclosure, it should be understood that the orientations or positional relationships indicated by the terms "center", "longitudinal", "lateral", "length", "width", "thickness", "above", "below", "front", "back", "left", "right", "vertical", "horizontal", "top", "bottom", "inner", "outer" and the like are the orientations or positional relationships based on the drawings, and those terms are used simply for conveniently describing the present disclosure and simplifying the description, rather than indicating or implying that the device or element referred to must have a particular orientation or must be constructed and operated in a particular orientation, and therefore, those terms should not be considered as limitation to the present disclosure. In addition, the structural elements having the same or similar characteristics can be identified by the same or different reference numerals in the present disclosure. Furthermore, the terms "first" and "second" are used only for the purpose of description, and should not be interpreted as indicating or implying relative importance or implicitly indicating the number of the technical features referred to. Thus, a feature defined by "first" or "second" may explicitly or implicitly include one or more features. In the description of the present disclosure, unless specifically limited otherwise, "a plurality" means two or more.

In the present disclosure, the word "exemplary" is used to mean "serving as an example, instance, or illustration". Any embodiment described herein as being "exemplary" is not necessarily to be interpreted as being preferred or being advantageous over other embodiments. The above description is provided to enable any person skilled in the art to implement or use the present disclosure. In the above description, various details are listed for the purpose of explanation. It should be understood by those of ordinary skill in the art that the present disclosure may be implemented without using these specific details. In other embodiments, well-known structures and processes are not described in detail, so as to prevent the description of the present disclosure from being obscure due to the unnecessary details. Thus, the present disclosure is not intended to be limited to the embodiments described herein, but falls within the widest scope of the principle and features disclosed herein.

## Claims

1. A bearing device for a semiconductor process apparatus, comprising:
a base, which comprises a first surface and a second surface, the first surface being configured to bear a wafer, a height of the second surface being smaller than a height of the first surface, and the second surface being disposed around the first surface;
a deposition ring, which comprises an upper surface provided with an annular groove, and a lower surface covering the second surface; and
a cover ring, an outer ring portion of the cover ring being supported on a liner of a reaction chamber of the semiconductor process apparatus, an inner ring portion of the cover ring covering an outer ring portion of the deposition ring, and a plurality of annular protrusions and a plurality of annular recesses being disposed at two opposite surfaces between the inner ring portion of the cover ring and the outer ring portion of the deposition ring, so as to form a labyrinth passage between the annular groove and contact parts of the cover ring and the deposition ring.

2. The bearing device of claim 1 wherein the plurality of annular protrusions are different in height, and the plurality of annular recesses are different in depth;
the plurality of annular protrusions are all disposed at an upper surface of the outer ring portion of the deposition ring, and the plurality of annular recesses are all disposed at a lower surface of the inner ring portion of the cover ring; or
the plurality of annular protrusions are all disposed at the lower surface of the inner ring portion of the cover ring, and the plurality of annular recesses are all disposed at the upper surface of the outer ring portion of the deposition ring; or
part of the plurality of annular protrusions and part of the plurality of annular recesses are disposed at the upper surface of the outer ring portion of the deposition ring, and the rest of the plurality of annular protrusions and the rest of the plurality of annular recesses are disposed at the lower surface of the inner ring portion of the cover ring.

3. The bearing device of claim 1, wherein the inner ring portion of the cover ring has an eave structure, which covers part of the annular groove.

4. The bearing device of claim 1, wherein the base comprises a first cylinder and a second cylinder, the first cylinder and the second cylinder are coaxially arranged and connected to each other, the first cylinder is located on the second cylinder, and a radius of a bottom surface of the first cylinder is smaller than a radius of a bottom surface of the second cylinder, so as to respectively form the first surface and the second surface on an upper side of the base; and an inner ring portion of the deposition ring and an outer sidewall of the first cylinder are positioned by engagement of a plurality of first positioning bosses and a plurality of first positioning grooves in a one-to-one correspondence manner.

5. The bearing device of claim 1, wherein the inner ring portion of the cover ring and the outer ring portion of the deposition ring are positioned by engagement of a plurality of second positioning bosses and a plurality of second positioning grooves in a one-to-one correspondence manner.

6. The bearing device of claim 1, wherein the outer ring portion of the deposition ring is further provided with a plurality of buckle slots, the bearing device further comprises a plurality of buckles, and the outer ring portion of the deposition ring is fastened to the base by engagement of the plurality of buckles and the plurality of buckle slots in a one-to-one correspondence manner.

7. The bearing device of claim 6, wherein each of the plurality of buckles comprises a buckle rod, a first hook is provided at one end of the buckle rod to be hooked to a corresponding buckle slot, and a second hook is provided at the other end of the buckle rod to be hooked to a bottom surface of the base.

8. The bearing device of claim 7, wherein the buckle slot is a T-shaped slot, and the first hook is a T-shaped hook which fits the T-shaped slot.

9. The bearing device of claim 7, further comprising:
a fixing ring, which is disposed around an outer sidewall of the base, and fastens the plurality of buckles to the outer sidewall of the base.

10. The bearing device of claim 9, wherein a third hook is provided at the other end of the buckle rod to be hooked to the fixing ring.

11. A semiconductor process apparatus, comprising the bearing device of any one of claims 1 to 10, a reaction chamber with enclosed space, and a semiconductor processing assembly, wherein the bearing device and the semiconductor processing assembly are disposed in the enclosed space.
